(19) Europäisches Patentamt

European Patent Office

Office européen des brevets

(11) **EP 4 776 822 A1**

(12) **EUROPEAN PATENT APPLICATION**
published in accordance with Art. 153(4) EPC

(43) Date of publication:
15.07.2026 Bulletin 2026/29

(21) Application number: 24862930.5

(22) Date of filing: 06.09.2024

(51) International Patent Classification (IPC):
$H10N\ 10/13^{(2023.01)}$  $B60R\ 21/264^{(2006.01)}$
$F16K\ 17/38^{(2006.01)}$  $G08B\ 17/06^{(2006.01)}$
$H02N\ 11/00^{(2006.01)}$

(52) Cooperative Patent Classification (CPC):
B60R 21/264; F16K 17/38; G08B 17/06;
H02N 11/00; H10N 10/13

(86) International application number:
PCT/JP2024/032125

(87) International publication number:
WO 2025/053281 (13.03.2025 Gazette 2025/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 07.09.2023 JP 2023145694

(71) Applicant: Nippon Kayaku Kabushiki Kaisha
Tokyo 100-0005 (JP)

(72) Inventors:
• SASAMOTO, Kouichi
Himeji-shi, Hyogo 679-2123 (JP)
• SAEKI, Nobuyuki
Himeji-shi, Hyogo 679-2123 (JP)

(74) Representative: Gille Hrabal
Partnerschaftsgesellschaft mbB
Patentanwälte
Brucknerstraße 20
40593 Düsseldorf (DE)

(54) **POWER SUPPLY DEVICE AND OPERATION DEVICE**

(57) A power supply device is provided that can supply electric power without applying an electric current from the outside.

A power supply device 40 includes an ignition unit 41 including an auto-ignition agent, and includes a power generation unit 43 configured to generate electric power by using energy obtained by ignition of the auto-ignition agent.

FIG. 1

**Description**

TECHNICAL FIELD

The present invention relates to a power supply device and an activation device including the power supply device.

BACKGROUND ART

Devices that supply electric power have been conventionally known. For example, Patent Literature 1 discloses a thermal battery including an exothermic agent obtained by mixing a metal powder and an oxidant powder and press-molding the mixed powder. In the thermal battery of Patent Literature 1, electric power from the outside is applied to the thermal battery to amplify the electric power, and large electric power is supplied from the thermal battery.

CITATIONS LIST

PATENT LITERATURE

Patent Literature 1: Japanese Patent No. 5309557

SUMMARY OF INVENTION

TECHNICAL PROBLEMS

However, the thermal battery of Patent Literature 1 cannot supply electric power to a target device or the like unless an electric current is applied from the outside.
Therefore, an object of the present invention is to provide a power supply device capable of supplying electric power to a target device or the like without applying an electric current from the outside, and an activation device including the power supply device.

SOLUTIONS TO PROBLEMS

(1) The power supply device of the present invention includes an ignition unit including an auto-ignition agent, and includes a power generation unit configured to generate electric power by using energy obtained by ignition of the auto-ignition agent.
(2) In the power supply device of (1), the ignition unit preferably includes an exothermic agent configured to be burned by ignition of the auto-ignition agent to generate heat, a gas generating agent configured to be burned by ignition of the auto-ignition agent to generate a pressure, or a luminescent agent configured to be burned by ignition of the auto-ignition agent to emit light, and the energy is preferably obtained by emitting heat, a pressure, or light by ignition of the auto-ignition agent.
(3) In the power supply device of (1) or (2), the energy is preferably heat, and the power generation unit is preferably a thermoelectric element configured to generate electric power by a Seebeck effect when the energy is received by the power generation unit to cause a temperature difference in the power generation unit.
(4) In the power supply device of (1) or (2), the energy is preferably a pressure, and the power generation unit is preferably a piezoelectric element configured to receive the energy to generate electric power.
(5) In the power supply device of (1) or (2), the energy is preferably light, and the power generation unit is preferably a photoelectric element configured to receive the energy to generate electric power.
(6) The activation device of the present invention includes the power supply device of (1) or (2), and includes a pyrotechnic device or a fire detector configured to be supplied with electric power generated by the power generation unit and to be activated by the electric power.

ADVANTAGEOUS EFFECTS OF INVENTION

According to the present invention, it is possible to provide a power supply device capable of supplying electric power to a target device or the like without applying an electric current from the outside, and provide an activation device including the power supply device.

BRIEF DESCRIPTION OF DRAWINGS

FIG. 1 is a schematic view illustrating a power supply device according to a first embodiment of the present invention.

FIG. 2 is a schematic partial sectional view illustrating a high-pressure tank to which the power supply device of FIG. 1 is connected.

FIG. 3 is a schematic partial sectional view illustrating a safety valve of the high-pressure tank of FIG. 2.

FIG. 4 is a schematic view illustrating a vehicle to which the power supply device of FIG. 1 and the high-pressure tank of FIG. 2 are attached.

FIG. 5 is a schematic view illustrating a power supply device according to a second embodiment of the present invention.

FIG. 6 is a schematic view illustrating a power supply device according to a third embodiment of the present invention.

FIG. 7 is a schematic view illustrating a power supply device according to a fourth embodiment of the present invention.

FIG. 8 is a schematic partial sectional view illustrating an example of an activation device including a pyrotechnic device to which the power supply device of FIG. 1 is connected.

FIG. 9 is a schematic partial sectional view illustrating an example of an activation device including a fire detector to which the power supply device of FIG. 1 is connected.

FIG. 10 is a table showing specifications of assemblies No. 1 to No. 3.

FIG. 11 is a schematic view illustrating the assembly No. 2 and the like.

FIG. 12 is a graph showing results of an experiment using the assembly No. 1.

FIG. 13 is a graph showing results of an experiment using the assembly No. 2.

FIG. 14 is a graph showing results of an experiment using the assembly No. 3.

DESCRIPTION OF EMBODIMENTS

<First embodiment>

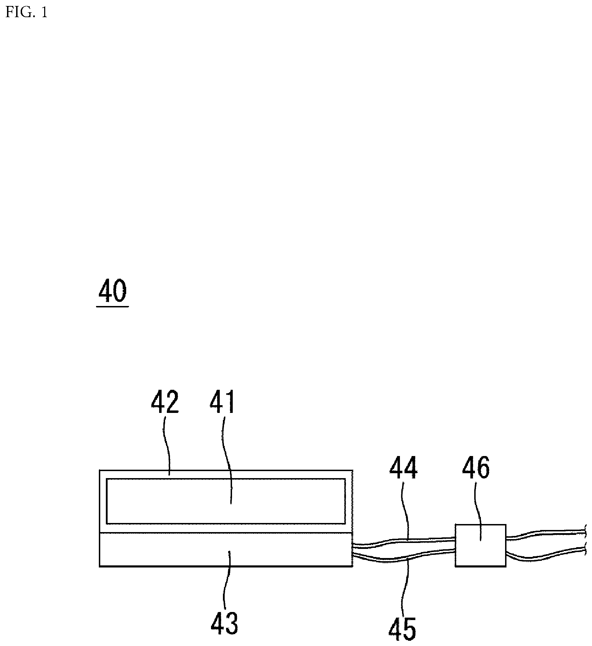

Hereinafter, a power supply device, a high-pressure tank, a safety valve, and a vehicle according to a first embodiment of the present invention will be described with reference to FIGS. 1 to 4.

First, a power supply device 40 according to the present embodiment will be described.

The power supply device 40 is a device that supplies electric power. As illustrated in FIG. 1, the power supply device 40 includes an ignition unit 41, a metal portion 42, a power generation unit 43, wirings 44 and 45, and a filter circuit 46.

The ignition unit 41 is molded into a pellet shape, and the ignition unit 41 is obtained by mixing and molding an auto-ignition agent with an exothermic agent so as to ignite when the ignition unit 41 reaches a predetermined temperature (for example, 200°C) or higher, or obtained by separately molding an auto-ignition agent and an exothermic agent. Alternatively, the ignition unit 41 may be not molded into a pellet shape, and may have any shape of a powder, a granule, a column, a sheet, a sphere, a cylinder with a single hole, a cylinder with multiple holes, a tablet, or the like. The ignition unit 41 may be held in a container or the like. Hereinafter, the auto-ignition agent may be referred to as an AI agent.

The AI agent has an auto-ignition (AI) function of automatically igniting in response to heat having a temperature of a predetermined temperature or higher.

As the AI agent, for example, an explosive that ignites at a relatively low temperature is used. Specific examples of the AI agent to be used include compositions containing 5-aminotetrazole/molybdenum trioxide as main components, such as compositions including B/5-aminotetrazole/potassium nitrate/molybdenum trioxide, 5-aminotetrazole/potassium nitrate/molybdenum trioxide, or 5-aminotetrazole/potassium nitrate/strontium nitrate/molybdenum trioxide, compositions including 3-nitro-1,2,4-triazole-5-one/sodium nitrate, and smokeless powders containing nitrocellulose as a main component. Furthermore, in compositions including a carbohydrate/an oxohalogen acid salt, carbohydrates can be used such as sucrose, lactose, glucose, powdered cellulose, dextrin, and charcoal singly or in the form of a mixture thereof. Sucrose is preferable as a carbohydrate having an ignition temperature of 165 to 220°C. Salts usable as the oxohalogen acid salt include chlorates and perchlorates such as potassium chlorate, potassium perchlorate, sodium chlorate, sodium perchlorate, barium chlorate, and barium perchlorate, bromates and perbromates such as potassium bromate, potassium perbromate, sodium bromate, and sodium perbromate, and iodates and periodates such as potassium iodate, potassium periodate, sodium iodate, and sodium periodate, and chlorates and perchlorates are particularly preferable from the viewpoint of ease of handling. Potassium chlorate and potassium perchlorate are more preferable.

For example, the AI agent contains the following component (A) or (B).

(A) A fuel component, an oxidant, and a combustion modifier are bonded with a binder and molded to obtain an AI agent. Here, examples of the fuel component include nitrogen atom-containing organic substances including aminotetrazole or a salt of aminotetrazole. Examples of the oxidant include oxidants containing 50 wt% or more of a nitrate. Examples of the combustion modifier include molybdenum, iron, and oxides thereof. Examples of the binder include binders selected from the following groups (1), (2), and (3).

(1) Hydrotalcite compound represented by the following general formula $[M^{2+}_{1-x}M^{3+}_x(OH)_2]^{x+}[A^{n-}_{x/n}\cdot mH_2O]^{x-}$

$M^{2+}$: divalent metal such as $Mg^{2+}$, $Mn^{2+}$, $Fe^{2+}$, $Co^{2+}$, $Ni^{2+}$, $Cu^{2+}$, or $Zn^{2+}$
$M^{3+}$: trivalent metal such as $Al^{3+}$, $Fe^{3+}$, $Cr^{3+}$, $Co^{3+}$, or $In^{3+}$
$A^{n-}$: n-valent anion such as $OH^-$, $F^-$, $Cl^-$, $Br^-$, $NO_3^-$, $CO_3^{2-}$, $SO_4^{2-}$, $Fe(CN)_6^{3-}$, $CH_3COO^-$, oxalate ion, or salicylate ion

$$x: 0 < x \leq 0.33$$

(2) Acidic clay
(3) Polymeric binder

At the time of forming the explosive into a desired molded body, the polymeric binder can improve the breaking strength and another mechanical property. Specific examples of the polymeric binder include metal salts of carboxymethyl cellulose, polysaccharide derivatives such as hydroxyethyl cellulose, hydroxypropyl methyl cellulose, cellulose acetate, cellulose propionate, cellulose acetate butyrate, nitrocellulose, guar gum, polyvinyl alcohol, polyacrylamide, and starch, and organic binders such as stearate, fluororubber, and SBS rubber. These polymeric binders may be used singly or in combination of two or more kinds thereof.

(B) The AI agent contains each component at each composition ratio of 3 to 25 (wt%) of (a) 5-aminotetrazole, 5 to 30 (wt%) of (b) boron, 50 to 85 (wt%) of (c) potassium nitrate, and 0.2 to 10 (wt%) of (d) molybdenum trioxide, and has a calorific value of 4500 J/g or more.

The exothermic agent is burned by ignition of the AI agent to generate heat. Specifically, when the AI agent ignites, the exothermic agent is ignited and burned by fire generated by the AI agent, and as a result of burning, generates heat having a high temperature.

Examples of the exothermic agent to be used include explosives configured to be burned to generate relatively high heat. Specifically, as the exothermic agent, an explosive is used that contains boron and potassium nitrate as main components, or contains silicon, copper oxide, potassium nitrate, and the like as main components.

The metal portion 42 is in contact with the ignition unit 41 to enable heat transfer between the metal portion 42 and the ignition unit 41. That is, if the metal portion 42 has a higher temperature than the ignition unit 41, the heat of the metal portion 42 is transferred to the ignition unit 41. For example, if the ignition unit 41 has a higher temperature than a part of the metal portion 42 (for example, immediately after another part of the metal portion 42 reaches a high temperature to ignite the ignition unit 41), the heat of the ignition unit 41 is transferred to the part of the metal portion 42. Note that the metal portion 42 has a heat transfer property, and is formed of, for example, copper, aluminum, or the like. The metal portion 42 is bonded, in the ignition unit 41, to a first main surface on the opposite side from the power generation unit 43, to a second main surface on the power generation unit 43 side, to a first end surface connecting the first main surface and the second main surface, and to a second end surface, on the opposite side from the first end surface, connecting the first main surface and the second main surface. Here, examples of a modification include the following. That is, the metal portion 42 and the ignition unit 41 may be separated, and another member may be provided between the metal portion 42 and the ignition unit 41, as long as heat can be transferred between the metal portion 42 and the ignition unit 41.

The power generation unit 43 generates electric power by using energy obtained by ignition of the Al agent. In the present embodiment, the exothermic agent is burned by ignition of the Al agent to generate heat, and as a result, the energy is obtained. The power generation unit 43 receives the energy from the metal portion 42 to generate electric power. The power generation unit 43 is in contact with the metal portion 42 and is bonded to the metal portion 42. Note that the power generation unit 43 and the metal portion 42 may be separated, and another member may be provided between the power generation unit 43 and the metal portion 42, as long as the power generation unit 43 can receive energy from the metal portion 42.

In the present embodiment, the energy is heat, and the power generation unit 43 is a thermoelectric element that receives the energy to generate electric power. Specifically, the power generation unit 43 is a thermoelectric element (Seebeck element) that generates electric power by a Seebeck effect when the energy is received by the power generation unit 43 to cause a temperature difference in the power generation unit 43. For example, when the metal portion 42 is heated, the heat of the metal portion 42 is transferred to the ignition unit 41 to ignite the Al agent, the exothermic agent is burned by ignition of the Al agent to generate heat, and the heat generated by the exothermic agent is transferred to the metal portion 42. The power generation unit 43 receives the heat generated by the exothermic agent from the metal portion 42, a temperature difference is caused between the metal portion 42 side and the opposite side from the metal portion 42 in the power generation unit 43, and thus electric power is generated by a Seebeck effect. A Seebeck effect is also exhibited with a temperature gradient of a single metal.

As described above, the power generation unit 43 can generate electric power without applying an electric current to the power supply device 40 from the outside. Therefore, an external power supply is unnecessary, and a wire harness or the like for connecting an external power supply and the power supply device 40 is also unnecessary, so that electric power can be generated with a simpler configuration.

Furthermore, a larger amount of electric power can be generated by increasing the temperature of the metal portion 42 side of the power generation unit 43 or by connecting a plurality of power generation units 43 in series. In the present embodiment, the exothermic agent can be used to increase the temperature of the metal portion 42 side of the power generation unit 43, and thus a larger amount of electric power can be generated without increasing the size of the power generation unit 43.

The power generation unit 43 and a device to which the power generation unit 43 supplies electric power (for example, a high-pressure tank 100 described below) can be disposed at separate places respectively, and thus at a place distant from the device, the ignition unit 41 can receive heat of a flame from the outside to make the power generation unit 43 generate electric power. Therefore, without being exposed to a flame from the outside, the device can be activated by the electric power supplied from the power generation unit 43. Furthermore, the external temperature can be determined at the time of power generation by the power generation unit 43 for activation of the device, by selecting an Al agent according to the temperature at which ignition is to be caused.

The wiring 44 is a positive-side wiring and is connected to the power generation unit 43. The wiring 45 is a negative-side wiring and is connected to the power generation unit 43. The electric power generated by the power generation unit 43 is supplied to the outside via the wirings 44 and 45.

The filter circuit 46 cuts off an electric current of a certain electric current value or less. For example, the filter circuit 46 includes a transistor protection circuit, a diode, and the like. Thus, it is possible to suppress supply of the electric power generated by the power generation unit 43 in an unintended situation, and it is possible to prevent malfunction of a device or the like activated by the electric power.

Next, the high-pressure tank 100 and a safety valve 30 in the present embodiment will be described.

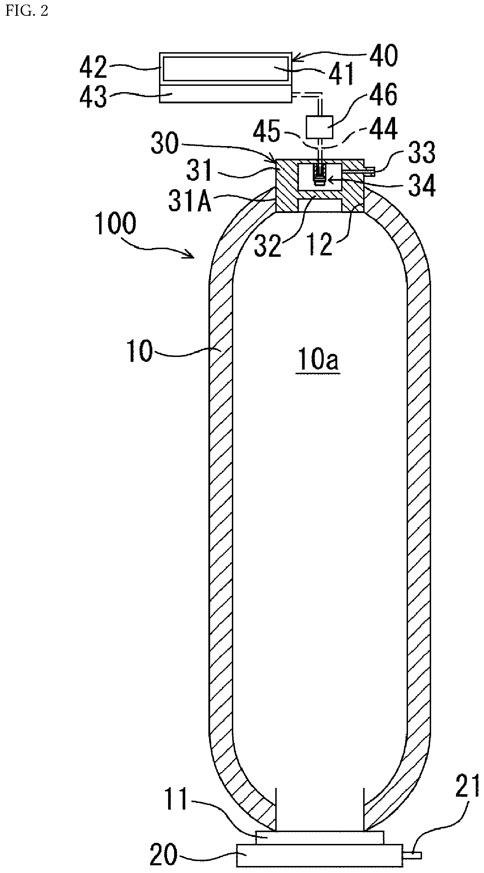

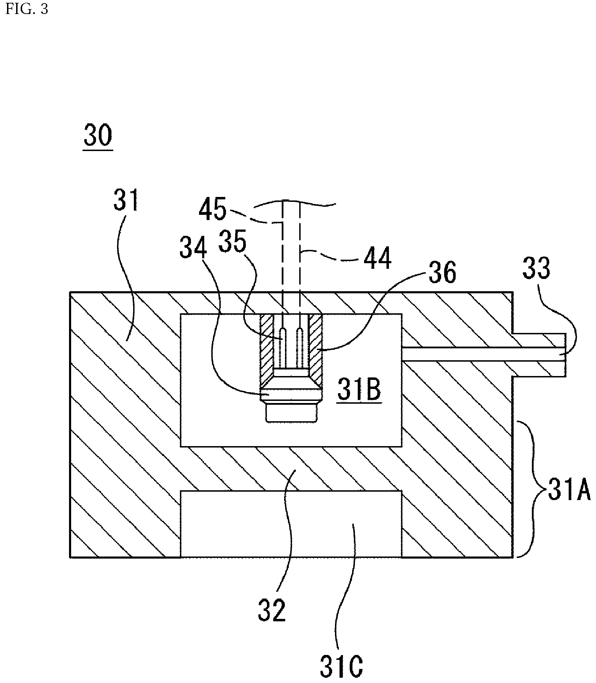

As illustrated in FIGS. 2 and 3, the high-pressure tank 100 includes a tank body 10 including a space 10a to be filled with a high-pressure gas (for example, hydrogen gas) for storage inside, an opening 11 provided at one end (lower end in FIG. 2) of the tank body 10, and an opening 12 provided at the other end (upper end in FIG. 2) of the tank body 10. The high-pressure tank 100 may contain another kind of compressed gas or liquefied gas.

The opening 11 is provided with a cap member (not illustrated), and a valve (tank valve) 20 is attached to the cap member. The valve 20 is provided with a supply port 21 for supply of a gas. To the supply port 21, for example, a pipe (not illustrated) is connected that leads to an engine that uses hydrogen as a power source, such as a fuel cell or a hydrogen engine, and normally (when a high-temperature abnormality or the like due to a fire does not occur), the gas in the space 10a of the tank body 10 is supplied to the engine that uses hydrogen as a power source via the valve 20, the supply port 21, and the pipe.

The opening 12 has an internal thread (not illustrated), and an external thread (not illustrated) provided on a part of the tank body 10 side of the outer peripheral portion of the safety valve 30 (an external thread portion 31A on the tank body 10 side of the outer peripheral portion of a main body 31 described below) is screwed to the internal thread to attach the safety valve 30.

The safety valve 30 includes the main body 31 and an igniter 34 (an example of opening means that is provided, in a flow path described below in which the tank body 10 side is an upstream side of the gas flow, on the downstream side with respect to an openable portion 32 and opens the openable portion 32 by using energy obtained by driving (activation) as a driving source). The main body 31 includes the external thread portion 31A that is a portion having an external thread, an internal space 31B in which the igniter 34 is provided, a bore 31C that communicates with the space 10a of the tank body 10, the openable portion 32 that is a bottom portion of the bore 31C and is opened (a hole is formed by melting, cleavage, breakage, or the like) by ignition of the igniter 34, and a discharge port 33 that communicates with an external environment and discharges a gas at the time of activation.

Here, in a case where the space 10a of the tank body 10 is filled with a hydrogen gas, a material processed to be resistant to hydrogen embrittlement is preferably used in the main body 31, and for example, SUS316, SUS316L, or the like is preferably used.

In the openable portion 32, a weak portion such as a cut groove may be formed at a position exposed to a flame from the igniter 34. Thus, cleavage can be facilitated, and scattering can be suppressed. The openable portion 32 may be formed to have a plate thickness such that the openable portion 32 is not deformed by the in-tank gas pressure under a normal condition and is cleaved when the igniter 34 is activated. The openable portion 32 is integrally formed with the main body 31, but the present invention is not limited to this form. A form may be adopted in which a rupture disk is provided by providing a through hole and closing the through hole and the rupture disk is cleaved by activation of the igniter 34.

The size of the total opening area depends on the critical constant ($\sigma$), the gas constant (R), the temperature (T), the pressure (P) in the tank, the gas volume (V) in the tank, and the gas discharge time (t). The general formula is as follows.

[Mathematical Formula 1]

$$A = \frac{V\sqrt{RT}}{t\sigma P}$$

However, the volume in the tank such that storage is technically possible is determined, so that preparing a minute total opening area is difficult in terms of processing technique. Furthermore, if the total opening area is minute, the discharge port may be blocked by a foreign matter or the like, and the effect of discharging a gas may not be achieved. Meanwhile, if the total opening area is set to a certain value or more, the discharge speed of a gas is increased, and the high-concentration gas and oxygen in the air are mixed. Thus, the mixed gas may ignite, and a possibility of detonation or the like may be increased. In consideration of these comprehensively, the total opening area in the discharge port 33 is preferably 0.008 to 5.5 ($mm^2$), and more preferably 0.08 to 3.2 ($mm^2$) in order to discharge a gas at an appropriate speed.

The discharge port 33 is preferably provided toward the ground side, or is preferably provided with a pipe attached so as to discharge a gas to the ground side. Thus, a hydrogen gas can be discharged in an amount such that even if the hydrogen gas ignites, the influence is small (an amount such that damage to a person, a facility, or the like is less likely to occur) from the discharge port 33, and the hydrogen gas can be relatively smoothly discharged, so that even if a high-temperature abnormality or the like due to a fire occurs, it is possible to achieve both prevention of burst of the tank body 10 and reduction in the influence of ignition of the discharged hydrogen gas.

In the internal space 31B, a fixing member 36 is fixed to the external environment side (upper side in FIG. 3) and thus fixes and holds the igniter 34.

The igniter 34 is configured to generate a flame, and includes an ignition portion (not illustrated) and a pair of terminal pins 35. In the inside of the ignition portion, the ignition portion includes an ignition charge that ignites and burns at the time of activation to generate a flame, and includes a resistor for ignition of the ignition charge.

More specifically, the ignition portion includes a squib cup formed into a cup shape, and a plug that closes an opening end of the squib cup and hold the squib cup with the pair of terminal pins 35 that pass through the plug. The resistor (bridge wire) is attached so as to connect tips of the pair of terminal pins 35 inserted into the squib cup, and the squib cup is loaded with the ignition charge so that the ignition charge surrounds the resistor or is close to the resistor. The squib cup can be loaded with an enhancer agent and/or an AI agent, as necessary, in addition to the ignition charge.

Here, examples of the resistor generally used include a nichrome wire, and examples of the ignition charge generally used include zirconium · potassium perchlorate (ZPP), zirconium · tungsten · potassium perchlorate (ZWPP), and an ignition charge (basic copper nitrate, zirconium) lead tricinate. Examples of a composition used as a booster that emits a large amount of flame and further as an enhancer agent include compositions including a metal powder/an oxidant, represented by $B/KNO_3$, $B/NaNO_3$, $Sr(NO_3)_2$, and the like, thermit compositions, compositions including titanium hydride/potassium perchlorate, and compositions including titanium/potassium perchlorate, and examples of the AI agent used include compositions containing 5-aminotetrazole/molybdenum trioxide as main components, such as compositions including B/5-aminotetrazole/potassium nitrate/molybdenum trioxide, 5-aminotetrazole/potassium nitrate/molybdenum trioxide, or 5-aminotetrazole/potassium nitrate/strontium nitrate/molybdenum trioxide, compositions including 3-nitro-1,2,4-triazole-5-one/sodium nitrate, and smokeless powders containing nitrocellulose as a main component. The squib cup and the plug described above are generally made of a metal or plastic.

The pair of terminal pins 35 are connected to the ignition portion in order to ignite the ignition charge, and are connected to the power generation unit 43 (see FIG. 1) via wirings 44 and 45. As described above, the power generation unit 43 generates electric power by ignition of the AI agent in the ignition unit 41 when the AI agent reaches a predetermined temperature or higher, and a predetermined amount of electric current is applied to the pair of terminal pins 35 via the wirings 44 and 45. That is, when a predetermined amount of electric current is applied to the resistor, Joule heat is generated in the resistor, and the ignition charge starts to burn. The high-temperature flame generated by burning ruptures the squib cup containing the ignition charge. The time from application of an electric current to the resistor to activation of the igniter 34 is generally 2 [ms] or less in the case of using a nichrome wire in the resistor.

Next, the operation of the safety valve 30 in the high-pressure tank 100 in the present embodiment will be described.

Referring to FIGS. 2 and 3, when the ignition unit 41 is exposed to an abnormally high temperature of a predetermined temperature or higher, an electric current flows from the power generation unit 43 to the igniter 34 serving as a driving source via the wirings 44 and 45, and the igniter 34 is activated. The openable portion 32 is opened (a hole is formed by melting, cleavage, breakage, or the like) by a flame generated by activation of the igniter 34, and thus the internal space 31B and the bore 31C communicate with each other. As the internal space 31B and the bore 31C communicate with each other, the gas filling the space 10a in the tank body 10 is discharged to the external environment via the flow path formed in the bore 31C, the internal space 31B, and the discharge port 33.

The safety valve 30 having the above configuration enables discharge of a predetermined amount (for example, the amount such that even if ignition occurs, the influence is small) of a gas from the beginning of activation.

In particular in the case of using in the high-pressure tank 100 filled with a hydrogen gas, if the discharge port 33 has a diameter of 0.001 mm to 0.2 mm, more preferably 0.01 mm to 0.1 mm, a hydrogen gas can be discharged, from the discharge port 33, in an amount such that even if the hydrogen gas ignites, the influence is small, and furthermore, the hydrogen gas can be relatively smoothly discharged, so that even if a high-temperature abnormality or the like due to a fire occurs, it is possible to achieve both prevention of burst of the tank body 10 and reduction in the influence of ignition of the discharged hydrogen gas.

Next, a vehicle 1000 in the present embodiment will be described.

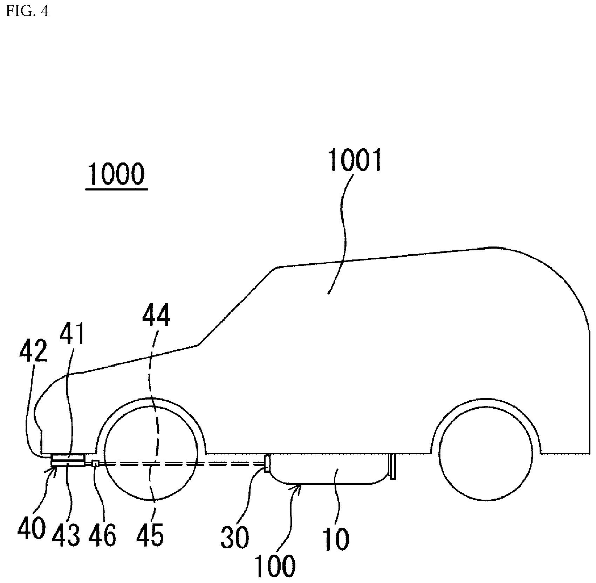

As illustrated in FIG. 4, the vehicle 1000 includes a vehicle body 1001 and the high-pressure tank 100 attached to a central portion of a lower portion of the vehicle body 1001. As described above, the high-pressure tank 100 includes the safety valve 30, and the safety valve 30 is connected to the power generation unit 43 via the wirings 44 and 45. The power generation unit 43 and the like are attached to a front portion (for example, an engine, a motor, or/and vicinity of a battery) of a lower portion of the vehicle body 1001. For example, the vehicle 1000 is a fuel cell vehicle.

Next, the operation of the safety valve 30 in the vehicle 1000 in the present embodiment will be described.

Referring to FIGS. 2 to 4, when an abnormality or the like occurs in the vehicle 1000 to cause the ignition unit 41 to be exposed to an abnormally high temperature of a predetermined temperature or higher, the AI agent ignites to cause a temperature difference in the power generation unit 43, a Seebeck effect causes an electric current to flow from the power generation unit 43 to the igniter 34 via the wirings 44 and 45, and the igniter 34 is activated. The openable portion 32 is opened (a hole is formed by melting, cleavage, breakage, or the like) by a flame generated by activation of the igniter 34, and the gas filling the tank body is discharged to the external environment via the flow path formed in the internal space 31B and the discharge port 33.

In the above configuration, an external power supply is unnecessary, and thus the weight of the vehicle 1000 can be reduced. Even in control when the vehicle 1000 is stopped or in a state where an electric current is not supplied to a sensor, fire detection (abnormality detection) can be carried out for safe activation.

As described above, for example, the power supply device 40 is installed at a position where the temperature becomes high at the time of abnormality in the vehicle 1000. A plurality of power supply devices 40 may be installed in the vehicle body 1001.

As described above, the power supply device 40 in the first embodiment of the present invention includes the ignition unit 41 including the auto-ignition agent, and includes the power generation unit 43 configured to generate electric power by using energy obtained by ignition of the auto-ignition agent.

Accordingly, when the temperature becomes a predetermined temperature or higher, electric power is generated by using energy obtained by ignition of the auto-ignition agent without applying an electric current from the outside. Therefore, electric power can be supplied without applying an electric current from the outside.

In the power supply device 40 in the first embodiment of the present invention, the ignition unit 41 includes the exothermic agent that is burned by ignition of the auto-ignition agent to generate heat, and the energy is obtained by emitting heat by ignition of the auto-ignition agent.

Accordingly, energy can be easily obtained by the exothermic agent. Therefore, electric power can be easily supplied without applying an electric current from the outside.

The power supply device 40 in the first embodiment of the present invention includes the metal portion 42 such that heat can be transferred between the metal portion 42 and the ignition unit 41.

Accordingly, heat can be easily transferred to the ignition unit 41 by the metal portion 42, so that the ignition unit 41 can easily ignite, and energy can be easily obtained. Therefore, electric power can be easily supplied to the igniter 34 without applying an electric current from the outside.

In the power supply device 40 in the first embodiment of the present invention, the power generation unit 43 receives energy from the metal portion 42 to generate electric power.

Accordingly, energy can be easily applied to the power generation unit 43 by the metal portion 42. Therefore, electric power can be easily supplied to the igniter 34 without applying an electric current from the outside.

In the power supply device 40 in the first embodiment of the present invention, the energy is heat, and the power generation unit 43 is a thermoelectric element configured to generate electric power by a Seebeck effect when the energy is received by the power generation unit 43 to cause a temperature difference in the power generation unit 43.

Accordingly, heat can be easily obtained by ignition of the Al agent, and thus a temperature difference can be easily caused in the power generation unit 43. Therefore, electric power can be easily supplied to the igniter 34 without applying an electric current from the outside.

<Second embodiment>

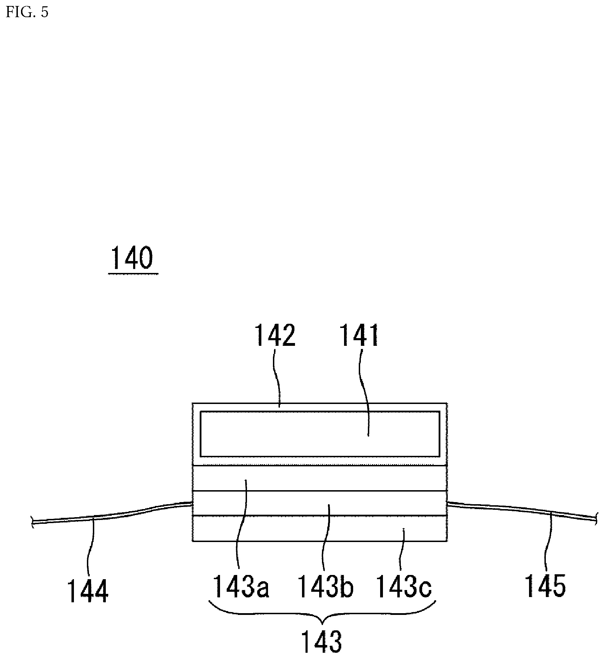

Next, a second embodiment of the present invention will be described with reference to FIG. 5. Note that a power supply device of the present embodiment is substantially similar to the power supply device of the first embodiment, and therefore description and illustration of a similar portion are omitted unless otherwise specified. A portion in the present embodiment and a portion in the above embodiment denoted by reference numerals having the same last two digits are similar to each other, and therefore description of the portion in the present embodiment will be omitted unless otherwise specified.

As illustrated in FIG. 5, a power supply device 140 is different from the power supply device 40 of the first embodiment mainly in that the power supply device 140 includes a power generation unit 143 instead of the power generation unit 43.

The power generation unit 143 includes a first metal layer 143a, an intermediate semiconductor layer 143b, and a second metal layer 143c, and the semiconductor layer 143b is interposed between the first metal layer 143a and the second metal layer 143c. Note that the power generation unit 143 may be any unit as long as it is formed by stacking two or more metal or semiconductor materials having different Seebeck coefficients in layers and it can generate an electric current when exposed to an abnormally high temperature of a predetermined temperature or higher. In general, when a temperature difference is caused between both ends of a metal or a semiconductor, a voltage proportional to the temperature difference is generated, and the term "Seebeck coefficient" refers to the proportionality coefficient between the temperature difference and the voltage. Here, examples of a combination of two semiconductors include a combination of an n-type semiconductor and a p-type semiconductor. In a case where two or more are selected from metals and semiconductors, for example, materials having different Seebeck coefficients are appropriately selected from the materials listed in the following combinations of two metals and the above combination of two semiconductors. Examples of the combination of two metals include iridium and rhodium, platinum and rhodium, copper and constantan, iron and constantan, copper and iron, gold and platinum, nickel and molybdenum, tungsten and rhenium, gold and palladium, and platinum and palladium.

For example, when a metal portion 142 is heated, the heat of the metal portion 142 is transferred to an ignition unit 141 to ignite an Al agent, an exothermic agent is burned by ignition of the Al agent to generate heat, the heat generated by the exothermic agent is transferred to the metal portion 142, and the first metal layer 143a receives the heat generated by the exothermic agent from the metal portion 142 and thus is heated. A temperature difference is caused between the first metal layer 143a and the second metal layer 143c, and thus the power generation unit 143 generates electric power by a Seebeck effect.

As described above, in the power supply device 140 in the second embodiment of the present invention, the power generation unit 143 is formed by stacking two or more metal or semiconductor materials having different Seebeck coefficients (the first metal layer 143a, the semiconductor layer 143b, and the second metal layer 143c) in layers.

Accordingly, a Seebeck effect can be easily exhibited in the power generation unit 143. Therefore, electric power can be easily supplied to a target device or the like without applying an electric current from the outside.

<Third embodiment>

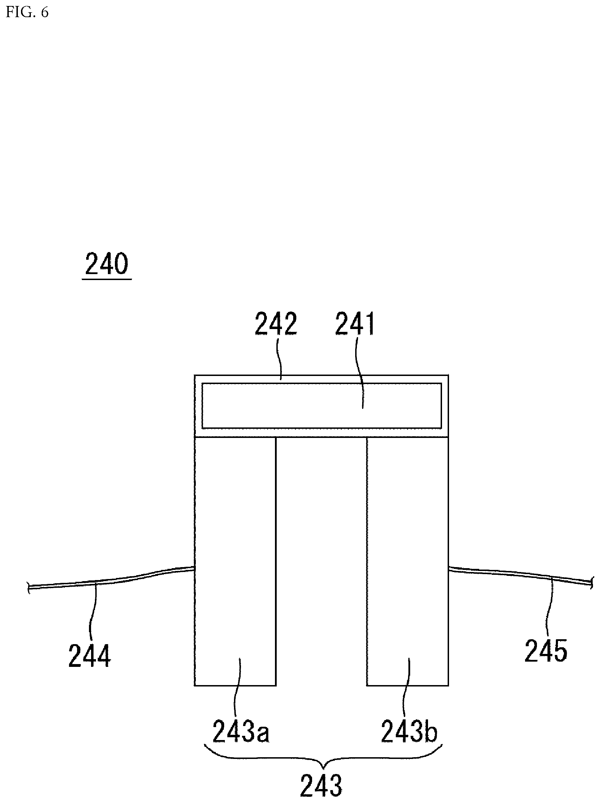

Next, a third embodiment of the present invention will be described with reference to FIG. 6. Note that a power supply device of the present embodiment is substantially similar to the power supply device of the first embodiment, and therefore description and illustration of a similar portion are omitted unless otherwise specified. A portion in the present embodiment and a portion in the above embodiment denoted by reference numerals having the same last two digits are similar to each other, and therefore description of the portion in the present embodiment will be omitted unless otherwise specified.

As illustrated in FIG. 6, a power supply device 240 is different from the power supply device 40 of the first embodiment mainly in that the power supply device 240 includes a power generation unit 243 instead of the power generation unit 43.

The power generation unit 243 includes a first semiconductor 243a and a second semiconductor 243b. The second semiconductor 243b has a Seebeck coefficient different from that of the first semiconductor 243a. One end portion of the first semiconductor 243a and one end portion of the second semiconductor 243b are electrically connected via a metal portion 242. For example, the first semiconductor 243a is an n-type semiconductor, and the second semiconductor 243b is a p-type semiconductor.

When the metal portion 242 is heated, the heat of the metal portion 242 is transferred to an ignition unit 241 to ignite an AI agent, an exothermic agent is burned by ignition of the AI agent to generate heat, the heat generated by the exothermic agent is transferred to the metal portion 242, and the one end portion of the first semiconductor 243a and the one end portion of the second semiconductor 243b receive the heat generated by the exothermic agent from the metal portion 242 and thus are heated. A temperature difference is caused between the one end portion and the other end portion in the first semiconductor 243a and between the one end portion and the other end portion in the second semiconductor 243b, and thus the power generation unit 243 generates electric power by a Seebeck effect.

As described above, in the power supply device 240 in the third embodiment of the present invention, the power generation unit 243 includes the first semiconductor 243a and the second semiconductor 243b having a Seebeck coefficient different from that of the first semiconductor 243a, and the one end portion of the first semiconductor 243a and the one end portion of the second semiconductor 243b are electrically connected.

Accordingly, a Seebeck effect can be easily exhibited in the power generation unit 243. Therefore, electric power can be easily supplied to a target device or the like without applying an electric current from the outside.

<Fourth embodiment>

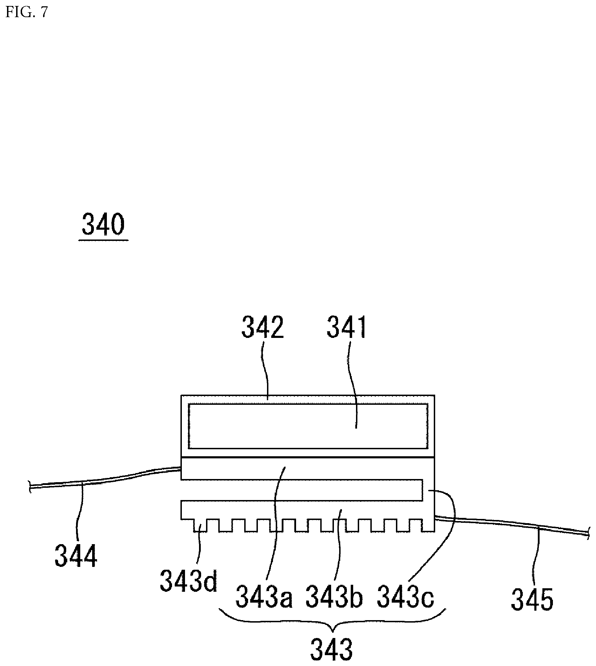

Next, a fourth embodiment of the present invention will be described with reference to FIG. 7. Note that a power supply device of the present embodiment is substantially similar to the power supply device of the first embodiment, and therefore description and illustration of a similar portion are omitted unless otherwise specified. A portion in the present embodiment and a portion in the above embodiment denoted by reference numerals having the same last two digits are similar to each other, and therefore description of the portion in the present embodiment will be omitted unless otherwise specified.

As illustrated in FIG. 7, a power supply device 340 is different from the power supply device 40 of the first embodiment mainly in that the power supply device 340 includes a power generation unit 343 instead of the power generation unit 43.

The power generation unit 343 is made of one kind of metal, and includes a first portion 343a provided on a metal portion 342 side, a second portion 343b provided on the opposite side from the metal portion 342 so as to face the first portion 343a, and a connection portion 343c electrically connecting an end portion of the first portion 343a and an end portion of the second portion 343b. The second portion 343b includes a protrusion 343d on the opposite side from the first portion 343a, and the power generation unit 343 is a heat sink.

When the metal portion 342 is heated, the heat of the metal portion 342 is transferred to an ignition unit 341 to ignite an AI agent, an exothermic agent is burned by ignition of the AI agent to generate heat, the heat generated by the exothermic agent is transferred to the metal portion 342, and the first portion 343a receives the heat generated by the exothermic agent from the metal portion 342 and thus is heated. A temperature difference is caused between the first portion 343a and the second portion 343b, and thus the power generation unit 343 generates electric power by a Seebeck effect.

As described above, in the power supply device 340 in the fourth embodiment of the present invention, the power generation unit 343 is formed of one kind of metal.

Accordingly, a Seebeck effect can be exhibited by one kind of metal. Therefore, electric power can be supplied to a target device or the like without applying an electric current from the outside while an increase in the kinds of metals to be used is suppressed.

<Other embodiments>

Although the embodiments of the present invention are described above, they are merely examples and do not particularly limit the present invention, and the specific configurations and the like can be appropriately modified in design. The embodiments of the present invention merely describe the most suitable actions and effects resulting from the present invention, and actions and effects according to the present invention are not limited to those described in the embodiments of the present invention.

The first embodiment describes a case in which the energy is heat and the power generation unit 43 is a thermoelectric element configured to generate electric power by a Seebeck effect when the energy is received by the power generation unit 43 to cause a temperature difference in the power generation unit 43, but the present invention is not limited to this case.

For example, the energy is a pressure, and the power generation unit 43 may be a piezoelectric element that receives the energy to generate electric power. In this case, for example, the ignition unit 41 may include a gas generating agent that burns to generate a pressure, and the energy may be obtained by generating a pressure by ignition of the AI agent. When the metal portion 42 is heated, the heat of the metal portion 42 is transferred to the ignition unit 41 to ignite the AI agent, the gas generating agent is burned by ignition of the AI agent to generate a gas, resulting in generation of a pressure of the gas generated by the gas generating agent. The power generation unit 43 receives the pressure of the gas generated by the gas generating agent and generates electric power.

Accordingly, a pressure can be easily obtained by ignition of the AI agent, and thus a pressure can be easily applied to the power generation unit 43. Therefore, electric power can be easily supplied without applying an electric current from the outside.

Alternatively, the energy may be light, and the power generation unit 43 may be a photoelectric element that receives the energy to generate electric power. In this case, for example, the ignition unit 41 may include a luminescent agent that burns to emit light, and the energy may be obtained by emitting light by ignition of the AI agent. When the metal portion 42 is heated, the heat of the metal portion 42 is transferred to the ignition unit 41 to ignite the AI agent, and the luminescent agent is burned by ignition of the AI agent to generate light. The power generation unit 43 receives the light generated by the luminescent agent and generates electric power.

Accordingly, light can be easily obtained by ignition of the AI agent, and thus the power generation unit 43 can be easily irradiated with light. Therefore, electric power can be easily supplied without applying an electric current from the outside.

The third embodiment describes a case in which the power generation unit 243 includes the first semiconductor 243a and the second semiconductor 243b, but the present invention is not limited to this case.

For example, the power generation unit 243 may include a first metal member instead of the first semiconductor 243a, and may include a second metal member instead of the second semiconductor 243b. The second metal member has a Seebeck coefficient different from that of the first metal member. One end portion of the first metal member and one end portion of the second metal member are electrically connected via the metal portion 242. Examples of a combination of the first metal member and the second metal member include iridium and rhodium, platinum and rhodium, copper and constantan, iron and constantan, copper and iron, gold and platinum, nickel and molybdenum, tungsten and rhenium, gold and palladium, and platinum and palladium. In this case, when the metal portion 242 is heated, the heat of the metal portion 242 is transferred to the ignition unit 241 to ignite the AI agent, the exothermic agent is burned by ignition of the AI agent to generate heat, the heat generated by the exothermic agent is transferred to the metal portion 242, and the one end portion of the first metal member and the one end portion of the second metal member receive the heat generated by the exothermic agent from the metal portion 242 and thus are heated. A temperature difference is caused between the one end portion and the other end portion in the first metal member and between the one end portion and the other end portion in the second metal member, and thus the power generation unit 243 generates electric power by a Seebeck effect.

Accordingly, a Seebeck effect can be easily exhibited in the power generation unit 243. Therefore, electric power can be easily supplied without applying an electric current from the outside.

The fourth embodiment describes a case in which the power generation unit 343 is formed of one kind of metal, but the present invention is not limited to this case. For example, metals having different Seebeck coefficients may be used in the first portion 343a and the second portion 343b.

In each of the above embodiments, as the shape of the power generation unit that generates electric power by a Seebeck effect (in particular, the shape of the power generation unit formed of one kind of metal), various shapes can be adopted such as a layered shape, a plate shape, a rod shape, a linear shape, and the like, and a combination of these shapes.

Each of the above embodiments describes a case in which the ignition unit includes the exothermic agent, but the present invention is not limited to this case. The ignition unit need not include an exothermic agent. In this case, the heat generated by ignition of the AI agent is transferred to the metal portion, and the power generation unit receives energy from the metal portion.

Each of the above embodiments describes a case in which the power supply device includes the metal portion, but the present invention is not limited to this case. The power supply device need not include a metal portion. In this case, for example, the power generation unit is in contact with the ignition unit, and receives the energy obtained by ignition of the AI agent from the ignition unit.

The first embodiment describes a case in which the power supply device 40 is connected to the high-pressure tank, but the present invention is not limited to this case. For example, the power supply device may be connected to a sensor, a fire detector, an early fire detector, or the like that detects and notifies existence of a fire such as a flame, and may supply electric power to it. Alternatively, the power supply device may be connected to a pyrotechnic device, and may supply electric power to the pyrotechnic device.

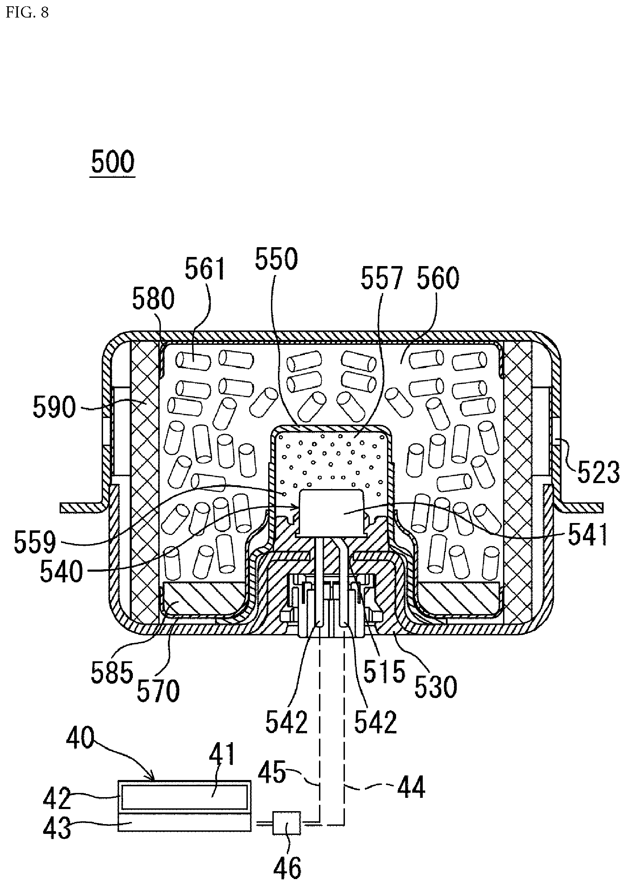

As illustrated in an example of an activation device of FIG. 8, the power supply device 40 may be connected to a gas generator 500, which is an example of the pyrotechnic device, and the electric power generated by the power generation unit 43 may be supplied to the gas generator 500.

The gas generator 500 is a disk-type gas generator, and includes a housing, a holding portion 530, an igniter 540, a cup-shaped member 550, a lower support member 570, an upper support member 580, a cushion material 585, and a filter 590. A housing space provided inside the housing contains internal components including a part of the holding portion 530, the igniter 540, the cup-shaped member 550, an enhance agent 559, a gas generating agent 561, the lower support member 570, the upper support member 580, the cushion material 585, and the filter 590. In the housing space provided inside the housing, a combustion chamber 560 is located that mainly houses the gas generating agent 561 among the above-described internal components.

The igniter 540 is configured to generate a flame, and includes an ignition portion 541 and a pair of terminal pins 542. The igniter 540 ignites and burns the gas generating agent 561. The ignition portion 541 is disposed inside the housing and ignites when an electric current flows. The ignition portion 541 includes an ignition charge that ignites and burns at the time of activation to generate a flame, and includes a resistor for ignition of the ignition charge. The pair of terminal pins 542 are a pair of terminal pins for application of an electric current to the ignition portion 541. The pair of terminal pins 542 are connected to the ignition portion 541 in order to ignite the ignition charge. The pair of terminal pins 542 extend through an opening 515 of the housing to the outside of the housing.

The wirings 44 and 45 are connected to the pair of terminal pins 542, and the power generation unit 43 is connected to the pair of terminal pins 542 via the wirings 44 and 45. The ignition unit 41 ignites, for example, when a flame is generated and thus the temperature around the power supply device 40 reaches a predetermined temperature or higher. The ignition of the ignition unit 41 causes the power generation unit 43 to generate electric power, and the electric power generated by the power generation unit 43 is supplied to the igniter 540 via the wirings 44 and 45 to activate the igniter 540. The enhance agent 559 housed in an enhancer chamber 557 is ignited and burned by the flame generated by the activation of the igniter 540 to cause rupture, deformation, or melting in a weak portion made of a fragile member in the cup-shaped member 550. As a result of rupture, deformation, or melting of the cup-shaped member 550, a large amount of heat particles generated by burning of the enhance agent 559 flows into the combustion chamber 560. When the enhance agent 559 and a large amount of heat particles generated by the enhance agent 559 flow into the combustion chamber 560, the gas generating agent 561 housed in the combustion chamber 560 is ignited and burned to generate a large amount of gas. The burning of the gas generating agent 561 causes an increase in the pressure of the space inside the housing, and accordingly, the gas is ejected to the outside of the housing through a gas ejection port 523.

As described above, the electric power generated by the power generation unit 43 is supplied to the gas generator 500.

Accordingly, when the temperature reaches a predetermined temperature or higher, the gas generator 500 can be supplied with electric power without applying an electric current from the outside, and thus can be activated.

Note that the power supply device 140, the power supply device 240, or the power supply device 340 instead of the power supply device 40 may be connected to the pyrotechnic device.

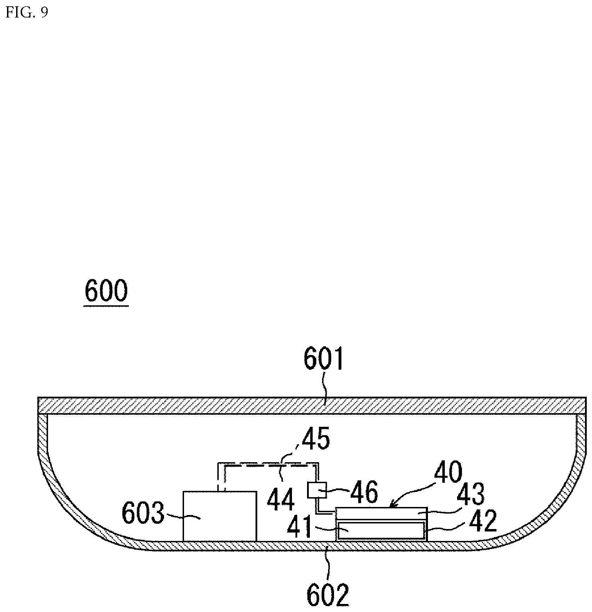

As illustrated in an example of an activation device of FIG. 9, the power supply device 40 may be connected to a fire detector 600, and the electric power generated by the power generation unit 43 may be supplied to the fire detector 600.

The fire detector 600 includes a base portion 601, a cover portion 602, and a warning sound generator 603. For example, the base portion 601 is attached to a ceiling in a room, or the like. The cover portion 602 is attached to the base portion 601. The warning sound generator 603 and the power supply device 40 are housed in the base portion 601 and the cover portion 602. For example, the warning sound generator 603 is a buzzer or a speaker that generates a warning sound. Instead of the warning sound generator 603, a light emitting unit (such as an LED) that emits light at the time of warning may be used, or a combination of the warning sound generator 603 and the light emitting unit may be used.

The wirings 44 and 45 are connected to the warning sound generator 603, and the power generation unit 43 is connected to the warning sound generator 603 via the wirings 44 and 45. The ignition unit 41 ignites, for example, when a flame is generated and thus the temperature in a room where the fire detector 600 is provided reaches a predetermined temperature or higher. The ignition of the ignition unit 41 causes the power generation unit 43 to generate electric power, and the electric power generated by the power generation unit 43 is supplied to the warning sound generator 603 via the wirings 44 and 45 to activate the warning sound generator 603. Activation of the warning sound generator 603 generates a warning sound.

As described above, the electric power generated by the power generation unit 43 is supplied to the fire detector 600.

Accordingly, when the temperature reaches a predetermined temperature or higher, the fire detector 600 can be supplied with electric power without applying an electric current from the outside, and thus can be activated.

Note that the power supply device 140, the power supply device 240, or the power supply device 340 instead of the power supply device 40 may be connected to the fire detector 600.

The power supply device 40 may be installed outside the fire detector 600. The power supply device 40 installed at any place and connected to the fire detector 600 by a wiring can function as a fire detection sensor without an electric source. Note that the power supply device 140, the power supply device 240, or the power supply device 340 instead of the power supply device 40 may be connected to the fire detector 600.

<Experimental results>

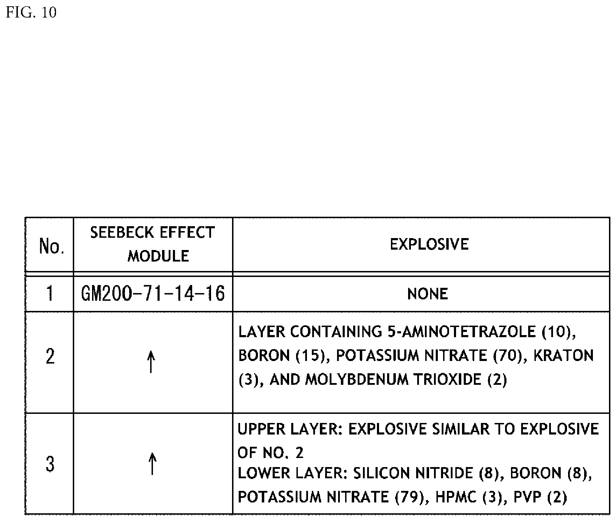

Next, voltage and temperature measurement experiments were performed in order to show that a device such as a power generator shown in the first embodiment can perform Seebeck power generation by a temperature difference at the time of local heating using an explosive. The experiments and the results will be described with reference to FIGS. 10 to 14.

As shown in FIG. 10, the above-described voltage and temperature measurement experiments were performed using assemblies No. 1 to No. 3. In the assembly No. 1, which is a comparative example, a Seebeck effect module with a model number GM200-71-14-16 (manufactured by European Thermodynamics Limited) was used as a power generation unit to obtain a power generator using no explosive, and details will be described below. In the assembly No. 2, a Seebeck effect module with the same model number GM200-71-14-16 as the assembly No. 1 was used, and an automatically ignitable enhancer agent composition containing 5-aminotetrazole (10 wt%), boron (15 wt%), potassium nitrate (70 wt%), Kraton (Kraton (trademark) FG Polymers manufactured by Kraton Corporation, product name: SEBS Maleated) (3 wt%), and molybdenum trioxide (2 wt%) was used as an explosive to obtain a power generator, and details will be described below. In the assembly No. 3, a Seebeck effect module with the same model number GM200-71-14-16 as the assembly No. 1 was used, the explosive used in the assembly No. 2 was used as an explosive in the upper layer, and an automatically ignitable enhancer agent composition containing silicon nitride (8 wt%), boron (8 wt%), potassium nitrate (79 wt%), hydroxypropyl methylcellulose (HPMC, 3 wt%), and polyvinylpyrrolidone (PVP, 2 wt%) was used as an explosive in the lower layer to obtain a power generator.

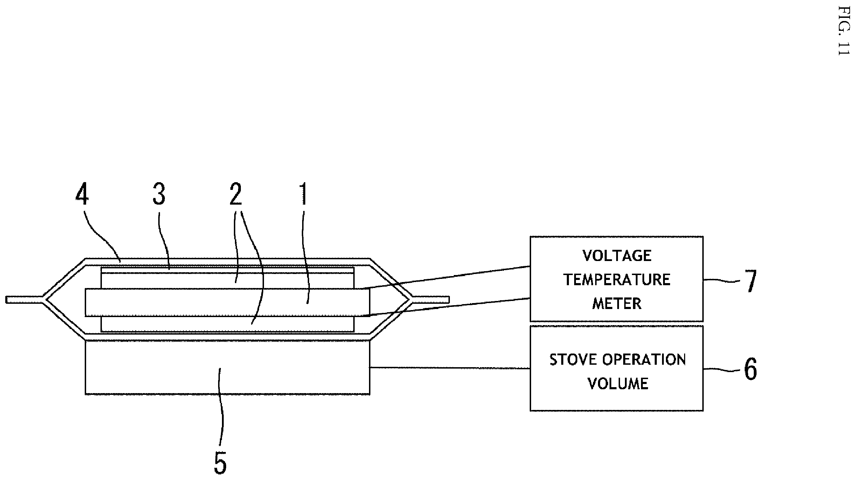

As illustrated in FIG. 11, the assembly No. 2 is obtained by reconfiguring the power generator shown in the first embodiment for an experiment. A copper plate 2 is attached to each of upper and lower surfaces of a Seebeck effect module 1 via a thermally conductive adhesive tape (not illustrated), and an explosive 3 is disposed on the copper plate 2. As described above, the explosive 3 is an automatically ignitable enhancer agent composition containing 5-aminotetrazole (10 wt%), boron (15 wt%), potassium nitrate (70 wt%), Kraton (Kraton (trademark) FG Polymers manufactured by Kraton Corporation, product name: SEBS Maleated) (3 wt%), and molybdenum trioxide (2 wt%).

The assembly No. 1 is different from the assembly No. 2 in that the assembly No. 1 does not include the explosive 3. The assembly No. 3 is different from the assembly No. 2 in that the assembly No. 3 includes an explosive having a two-layer structure instead of the explosive 3. The explosive of the assembly No. 3 includes a lower layer that is a layer on the copper plate 2 side, and an upper layer that is layered on the lower layer. As described above, the lower layer contains silicon nitride (8 wt%) and the like, and the upper layer is a layer made of an explosive similar to the explosive 3 of the assembly No. 2.

Each of the assemblies No. 1 to No. 3 was wrapped with an asbestos heat-resistant sheet 4, the assembly wrapped with the heat-resistant sheet 4 was disposed on a stove 5 that is for use in an AI test or the like, a stove operation volume 6 was operated to heat the assembly by the stove 5 at a temperature rise of 14°C/min, and a voltage and temperature meter 7 (HIOKI8875) was used to measure the voltage by the Seebeck effect module 1, the temperature of the upper surface of the copper plate 2 on the upper side of the Seebeck effect module 1, and the temperature of the lower surface of the copper plate 2.

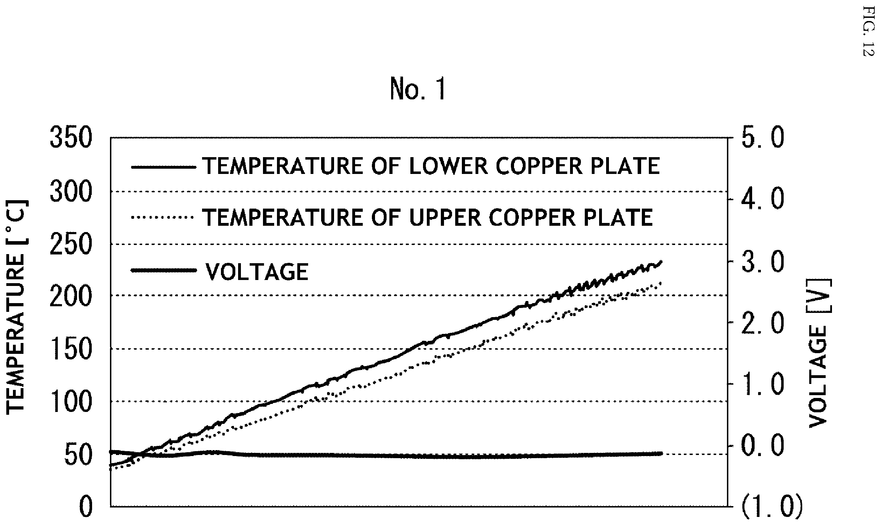

As shown in FIG. 12, in the assembly No. 1, no voltage was generated even when the assembly No. 1 was heated to a temperature at which the explosive of the assembly No. 2 or No. 3 ignited.

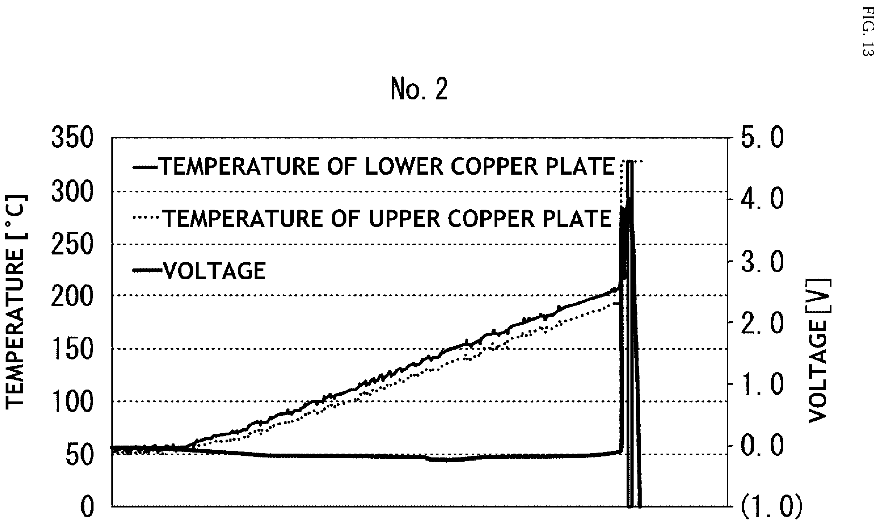

As shown in FIG. 13, in the assembly No. 2, the explosive ignited at 194°C, and a voltage of about 4 V at maximum was generated with the ignition of the explosive. The time from the ignition to generation of a voltage of 3 V or more was 0.7 s. The duration of continuous generation of a voltage of 3 V or more was 15.1 s.

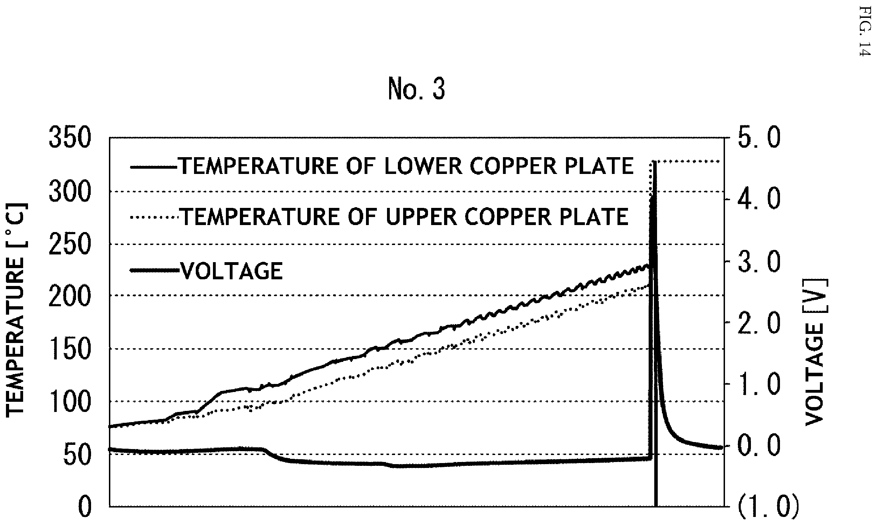

As shown in FIG. 14, in the assembly No. 3, the explosive ignited at 210°C, and a voltage of about 4 V at maximum was generated with the ignition of the explosive. The time from the ignition to generation of a voltage of 3 V or more was 1.6 s. The duration of continuous generation of a voltage of 3 V or more was 2.3 s.

From the above experimental results, it has been found that the ignition temperature of the explosive can be adjusted. Therefore, an electromotive force can be generated at any temperature. Furthermore, it has been found that an electromotive force can be generated in several seconds after ignition of the explosive. Therefore, the notification time range of an abnormal fire situation can be shortened. Furthermore, it has been found that an electromotive force of 3 V or more can be continued for 2.3 s to 15.1 s. Thus, it is possible to generate a continuous electromotive force, which is not an instantaneous electromotive force due to burning of an explosive.

REFERENCE SIGNS LIST

| | |
|---|---|
| 1 | seebeck effect module |
| 2 | copper plate |
| 3 | explosive |
| 4 | heat-resistant sheet |
| 5 | stove |
| 6 | stove operation volume |
| 7 | voltage and temperature meter |
| 10 | tank body |
| 10a | space |
| 11, 12 | opening |
| 20 | valve |
| 21 | supply port |
| 30 | safety valve |
| 31 | main body |
| 31A | external thread portion |
| 31B | internal space |
| 31C | bore |
| 32 | openable portion |
| 33 | discharge port |
| 34 | igniter |
| 35 | terminal pin |
| 36 | fixing member |
| 40, 140, 240, 340 | power supply device |
| 41, 141, 241, 341 | ignition unit |
| 42, 142, 242, 342 | metal portion |
| 43, 143, 243, 343 | power generation unit |
| 143a | first metal layer |
| 143b | semiconductor layer |
| 143c | second metal layer |
| 243a | first semiconductor |
| 243b | second semiconductor |
| 343a | first portion |
| 343b | second portion |
| 343c | connection portion |
| 343d | protrusion |
| 44, 45, 144, 145, 244, 245, 344, 345 | wiring |
| 46 | filter circuit |
| 100 | high-pressure tank |
| 500 | gas generator |
| 515 | opening |
| 523 | gas ejection port |
| 530 | holding portion |
| 540 | igniter |
| 541 | ignition portion |
| 542 | terminal pin |
| 550 | cup-shaped member |
| 557 | enhancer chamber |
| 559 | enhance agent |
| 560 | combustion chamber |
| 561 | gas generating agent |
| 570 | lower support member |
| 580 | upper support member |

| 585 | cushion material |
|---|---|
| 590 | filter |
| 600 | fire alarm |
| 601 | base portion |
| 602 | cover portion |
| 603 | warning sound generator |
| 1000 | vehicle |
| 1001 | vehicle body |

**Claims**

1. A power supply device comprising:

   an ignition unit including an auto-ignition agent; and
   a power generation unit configured to generate electric power by using energy obtained by ignition of the auto-ignition agent.

2. The power supply device according to claim 1, wherein

   the ignition unit includes an exothermic agent configured to be burned by ignition of the auto-ignition agent to generate heat, a gas generating agent configured to be burned by ignition of the auto-ignition agent to generate a pressure, or a luminescent agent configured to be burned by ignition of the auto-ignition agent to emit light, and the energy is obtained by emitting heat, a pressure, or light by ignition of the auto-ignition agent.

3. The power supply device according to claim 1 or 2, wherein

   the energy is heat, and
   the power generation unit is a thermoelectric element configured to generate electric power by a Seebeck effect when the energy is received by the power generation unit to cause a temperature difference in the power generation unit.

4. The power supply device according to claim 1 or 2, wherein

   the energy is a pressure, and
   the power generation unit is a piezoelectric element configured to receive the energy to generate electric power.

5. The power supply device according to claim 1 or 2, wherein

   the energy is light, and
   the power generation unit is a photoelectric element configured to receive the energy to generate electric power.

6. An activation device comprising:

   the power supply device according to claim 1 or 2; and
   a pyrotechnic device or a fire detector configured to be supplied with electric power generated by the power generation unit and to be activated by the electric power.

**Amended claims under Art. 19.1 PCT**

1. A power supply device comprising:

   an ignition unit including an auto-ignition agent contained in a sealed container; and
   a power generation unit configured to generate electric power by using energy obtained by ignition of the auto-ignition agent.

2. The power supply device according to claim 1, wherein

   the ignition unit includes an exothermic agent configured to be burned by ignition of the auto-ignition agent to generate heat, a gas generating agent configured to be burned by ignition of the auto-ignition agent to generate a pressure, or a luminescent agent configured to be burned by ignition of the auto-ignition agent to emit light, and the energy is obtained by emitting heat, a pressure, or light by ignition of the auto-ignition agent.

3. The power supply device according to claim 1 or 2, wherein

the energy is heat, and
the power generation unit is a thermoelectric element configured to generate electric power by a Seebeck effect when the energy is received by the power generation unit to cause a temperature difference in the power generation unit.

4. A power supply device comprising:

an ignition unit including an auto-ignition agent; and
a power generation unit configured to generate electric power by using energy obtained by ignition of the auto-ignition agent, wherein
the energy is a pressure, and
the power generation unit is a piezoelectric element configured to receive the energy to generate electric power.

5. A power supply device comprising:

an ignition unit including an auto-ignition agent; and
a power generation unit configured to generate electric power by using energy obtained by ignition of the auto-ignition agent, wherein
the energy is light, and
the power generation unit is a photoelectric element configured to receive the energy to generate electric power.

6. An activation device comprising:

the power supply device according to any one of claims 1, 4, and 5; and
a pyrotechnic device or a fire detector configured to be supplied with electric power generated by the power generation unit and to be activated by the electric power.

**Statement under Art. 19.1 PCT**

[0001] 1. Contents of Amendment

Claim 1 has been changed, regarding the auto-ignition agent of the original claim 1, to the configuration of "an auto-ignition agent contained in a sealed container."

Claims 4 and 5 have no substantial change in content from that as filed; however, since the original claim 1 has been amended as described above, a formal amendment has been made in the form of adding the text of the original claim 1.

Claim 6 has been configured to include the power supply device according to any one of claims 1, 4, and 5, which are independent claims.

2. Explanation

The power supply device of claims 1 to 3 has "an auto-ignition agent contained in a sealed container." Thus, deterioration of the explosive can be suppressed, deterioration due to disturbances such as moisture can be suppressed, and the duration and the function can be continued. In addition, in a case where a fire or the like occurs in the external environment, if it is not sealed, heat is directly transferred to the auto-ignition agent, and therefore the variation in the ignition temperature of the auto-ignition agent becomes remarkable. However, in the case of the "auto-ignition agent contained in a sealed container" of claim 1, heat transfer from the outside of the sealed container becomes indirect and becomes stable as compared with a case where it is not sealed; therefore, it becomes possible to adjust so as to "ignite when the ignition unit reaches a predetermined temperature or higher," and, as compared with a case where heat due to the fire or the like is directly transferred, the variation in the ignition temperature of the auto-ignition agent can be suppressed.

Claim 6 is a dependent claim of claims 1, 4, and 5.

Providing the configuration of the power supply device described in claims 1 to 3 is not described in any of the cited documents.

Also, providing the configuration of the activation device described in claim 6 is not described in any of the cited documents.

FIG. 1

FIG. 2

FIG. 3

FIG. 4

FIG. 5

FIG. 6

<u>240</u>

242    241

244    245

243a    243b

243

FIG. 7

FIG. 8

FIG. 9

FIG. 10

| No. | SEEBECK EFFECT MODULE | EXPLOSIVE |
|---|---|---|
| 1 | GM200-71-14-16 | NONE |
| 2 | ↑ | LAYER CONTAINING 5-AMINOTETRAZOLE (10), BORON (15), POTASSIUM NITRATE (70), KRATON (3), AND MOLYBDENUM TRIOXIDE (2) |
| 3 | ↑ | UPPER LAYER: EXPLOSIVE SIMILAR TO EXPLOSIVE OF NO. 2<br>LOWER LAYER: SILICON NITRIDE (8), BORON (8), POTASSIUM NITRATE (79), HPMC (3), PVP (2) |

FIG. 11

| VOLTAGE TEMPERATURE METER | 7 |
| STOVE OPERATION VOLUME | 6 |

1
2
3
4
5

FIG. 12

No. 1

FIG. 13

FIG. 14

EP 4 776 822 A1

## No. 3

Legend:
— TEMPERATURE OF LOWER COPPER PLATE
···· TEMPERATURE OF UPPER COPPER PLATE
— VOLTAGE

## INTERNATIONAL SEARCH REPORT

| | International application No. |
| --- | --- |
| | **PCT/JP2024/032125** |

| | |
| --- | --- |
| **A. CLASSIFICATION OF SUBJECT MATTER** | |
| ***H10N 10/13***(2023.01)i; ***B60R 21/264***(2006.01)i; ***F16K 17/38***(2006.01)i; ***G08B 17/06***(2006.01)i; ***H02N 11/00***(2006.01)i<br>FI:  H10N10/13; B60R21/264; F16K17/38 Z; G08B17/06 A; H02N11/00 A | |
| According to International Patent Classification (IPC) or to both national classification and IPC | |

| |
| --- |
| **B. FIELDS SEARCHED** |
| Minimum documentation searched (classification system followed by classification symbols) |
| H10N10/13; B60R21/264; F16K17/38; G08B17/06; H02N11/00 |
| Documentation searched other than minimum documentation to the extent that such documents are included in the fields searched |
| Published examined utility model applications of Japan 1922-1996<br>Published unexamined utility model applications of Japan 1971-2024<br>Registered utility model specifications of Japan 1996-2024<br>Published registered utility model applications of Japan 1994-2024 |
| Electronic data base consulted during the international search (name of data base and, where practicable, search terms used) |
| |

| | |
| --- | --- |
| **C. DOCUMENTS CONSIDERED TO BE RELEVANT** | |

| Category* | Citation of document, with indication, where appropriate, of the relevant passages | Relevant to claim No. |
| --- | --- | --- |
| X | US 2009/0071526 A1 (ALLOY SURFACES COMPANY, INC.) 19 March 2009 (2009-03-19) paragraphs [0004]-[0089], fig. 1-6 | 1-3, 6 |
| A | | 4, 5 |
| A | JP 2018-140649 A (NIPPON KAYAKU KABUSHIKI KAISHA) 13 September 2018 (2018-09-13) | 1-6 |
| A | JP 50-011060 B1 (MATSUSHITA ELECTRIC INDUSTRIAL CO., LTD.) 26 April 1975 (1975-04-26) | 1-6 |

☐ Further documents are listed in the continuation of Box C.  ☑ See patent family annex.

| | | | |
| --- | --- | --- | --- |
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| | |
| --- | --- |
| Date of the actual completion of the international search | Date of mailing of the international search report |
| **11 November 2024** | **19 November 2024** |
| Name and mailing address of the ISA/JP | Authorized officer |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
**Information on patent family members**

International application No.

**PCT/JP2024/032125**

| Patent document cited in search report | Publication date (day/month/year) | Patent family member(s) | Publication date (day/month/year) |
|---|---|---|---|
| US 2009/0071526 A1 | 19 March 2009 | WO 2009/039071 A1 | |
| JP 2018-140649 A | 13 September 2018 | (Family: none) | |
| JP 50-011060 B1 | 26 April 1975 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5309557 B